Europäisches Patentamt

European Patent Office

Office européen des brevets

(11) Veröffentlichungsnummer: **0 280 916**
**A1**

(12) **EUROPÄISCHE PATENTANMELDUNG**

(21) Anmeldenummer: **88101676.0**

(22) Anmeldetag: **05.02.88**

(51) Int. Cl.⁴: **G01R 31/36** , H01M 10/48

(30) Priorität: **25.02.87 DE 3706076**

(43) Veröffentlichungstag der Anmeldung:
**07.09.88 Patentblatt 88/36**

(84) Benannte Vertragsstaaten:
**AT BE CH DE ES FR GB GR IT LI LU NL SE**

(71) Anmelder: **ELEKTRON-BREMEN Fabrik für Elektrotechnik GmbH**
**Am Hohentorshafen 17-19**
**D-2800 Bremen(DE)**

(72) Erfinder: **Goldgrabe, Richard**
**Graf-Moltke-Strasse 67**
**D-2800 Bremen(DE)**

(74) Vertreter: **Bolte, Erich, Dipl.-Ing. et al**
**c/o Meissner, Bolte & Partner Patentanwälte**
**Hollerallee 73**
**D-2800 Bremen 1(DE)**

(54) Verfahren und Vorrichtung zur Überwachung des Bereitschaftszustandes eines batteriebetriebenen Fahrzeuges.

(57) Es werden Verfahren und Vorrichtung zur Überwachung des Bereitschaftszustandes eines batteriebetriebenen Fahrzeuges aufgezeigt, wobei man mindestens die Klemmenspannung an der Batterie mißt. Das Verfahren zeichnet sich dadurch aus, daß man die Klemmenspannung zeitdiskret abtastet, das Ergebnis mit einem Punkt auf mindestens einer Entlade-Spannungskennlinie vergleicht, deren Variable der momentane Entladungsgrad ist, und daß man mindestens die Differenz zwischen momentanem Entladegrad und erreichbarem Entladegrad entsprechend der Kennlinie als Ladezustand anzeigt.

Fig. 7

## Verfahren und Vorrichtung zur Überwachung des Bereitschaftszustandes eines batteriebetriebenen Fahrzeuges

Die Erfindung betrifft ein Verfahren nach dem Oberbegriff des Patentanspruches 1 sowie eine Vorrichtung nach dem Oberbegriff des Patentanspruches 21, die insbesondere zur Durchführung des Verfahrens geeignet ist.

Für eine ganze Reihe von Einsatzzwecken werden bereits Elektrofahrzeuge verwendet, die ihre Energie aus wiederaufladbaren Batterien, insbesondere aus Bleiakkumulatoren beziehen. Diese Art von Antrieben wird sich voraussichtlich aus Gründen des Umweltschutzes in gesteigertem Maße durchsetzen, wie dies allgemein bekannt ist.

Ein wesentliches Problem besteht hierbei darin, daß der Führer des Fahrzeuges bzw. bei führerlosen Fahrzeugen das Wartungspersonal über den Bereitschaftszustand des Fahrzeuges auf dem laufenden gehalten werden muß. Hierzu gehört zum einen die Anzeige des Ladezustandes der Batterie, zum anderen eine Anzeige der übrigen betriebsdauerabhängigen Parameter (Betriebsstunden etc.).

Bei Bleiakkumulatoren tritt zusätzlich noch das Problem auf, daß eine Entladung über einen gewissen Prozentsatz der an sich zur Verfügung stehenden Kapazität hinaus eine nachhaltige Schädigung der Zellen mit sich bringt, die insbesondere mit der Bildung grobkristallinen Sulfats zusammenhängt.

Zum Feststellen das Ladezustandes einer Batterie kann man nun den "Zustand", insbesondere die Dichte der Batteriesäure bestimmen, wie dies beispielsweise aus der DE-OS 24 15 033, der DE-AS 16 98 236 oder der DE-PS 24 62 039 bekannt ist. Der große Nachteil dieses Verfahrens liegt aber darin, daß die Vorrichtungen hierfür zum einen kompliziert sind, zum anderen nur der Ladezustand einer einzigen Zelle eines ganzen Batterieaggregats festgestellt werden kann.

Aus der DE-OS 25 58 526 ist ein Verfahren zur Überwachung des Ladezustandes einer Batterie bekannt, bei dem eine Vielzahl von Spannungsreferenzstufen mit der momentanen Batteriespannung (Klemmenspannung) verglichen wird und die Zeit beim Unterschreiten enes Referenzwertes bis zu einem Grenzwert integriert wird, bei dem dann die nächsttiefere Stufe als Referenzwert verwendet wird. Bei diesem Verfahren wird aber von einem Normzustand der Batterie, z.B. einer konstanten Umgebungstemperatur, einem konstanten Mittel-Entladestromwert und einem bestimmten Maximalstromwert ausgegangen. Wenn das tatsächliche Betriebsverhalten des Fahrzeuges zu anderen Batteriebelastungen führt, so ist die Anzeige nicht mehr korrekt.

Aus der DE-AS 23 21 108 ist eine Einrichtung zur Kontrolle und Überwachung des Entladezustandes einer Batterie bekannt, bei dem ein Strommeßshunt zur Kompensation der Klemmenspannung im Hinblick auf den Laststrom verwendet wird. Durch diese Einrichtung können zwar Veränderungen des Betriebsverhaltens mit in die Messung einbezogen werden, jedoch werden auch hier nur relativ ungenaue Anzeigen im Hinblick z.B. auf die Umgebungstemperatur oder insbesondere dann erhalten, wenn man die Batterie kurzzeitig zwischenlädt (z.B. durch Nutzbremsung oder dergleichen).

Weiterhin ist es bekannt, die der Batterie tatsächlich entnommene Energie zu messen und mit der anfänglich in der Batterie gespeicherten Ladung zu vergleichen (FR-A-2 361 754). Auch hier tritt wieder das Problem auf, daß die einfache Subtraktion der entnommenen Ladung von der anfänglich in der Batterie enthaltenen Ladung keineswegs den tatsächlichen Ladezustand der Batterie anzeigt, da die entnehmbare Ladung nicht gleichzusetzen ist mit der anfänglich bei voll geladener Batterie gespeicherten Ladung.

Ausgehend vom oben genannten Stand der Technik, ist es Aufgabe der vorliegenden Erfindung, ein Verfahren der eingangs genannten Art dahingehend weiterzubilden, daß eine möglichst genaue Überwachung des Bereitschaftszustandes eines batteriebetriebenen Fahrzeuges erzielt wird. Diese Aufgabe wird durch die in den Patentansprüchen 1 oder 14 angegebenen Merkmale gelöst. Eine Vorrichtung zur Durchführung des Verfahrens ist im Anspruch 21 beschrieben.

Der Erfindungsgedanke basiert in erster Linie darauf, daß man zeitdiskret abtastet und die Abtastwerte mindestens mit einer Kennlinie, welche für die Batterie charakteristisch ist, vergleicht und aus diesem Vergleichswert den tatsächlichen Ladezustand herleitet. Bei einer bevorzugten Ausführungsform der Erfindung ist diese Kennlinie (vorzugsweise sind es Kennlinienfelder) gespeichert, während bei einer anderen bevorzugten Ausführungsform die Kennlinie(n) errechnet wird (werden).

Weitere erfindungswesentliche Details ergeben sich aus den Unteransprüchen und der nachfolgenden Beschreibung von Beispielen bevorzugter Ausführungsformen, die anhand von Abbildungen näher erläutert werden. Hierbei zeigen:

Fig. 1 ein Kennlinienfeld der mittleren Batteriespannung in Abhängigkeit vom Entladegrad bei verschiedenen Entladeströmen;

Fig. 2 ein Kennlinienfeld des erreichbaren Entladegrades über den maximalen Entladestrom in Abhängigkeit vom Tastverhältnis der Entladung (Stromflußzeit dividiert durch Zykluszeit);

Fig. 3 ein Kennlinienfeld der Abhängigkeit der Batteriespannung vom Entladegrad bei verschiedenen (fortlaufend in Pfeilrichtung steigenden) Entladeströmen;

Fig. 4 ein Kennlinienfeld der Batteriespannung über den Ladegrad bei verschiedenen Batterie-Temperaturen und zwar für Entladung mit konstantem Strom;

Fig. 5 ein Kennlinienfeld ähnlich dem nach Fig. 4 jedoch bei Entladung mit über die Zeit variierender Stromstärke;

Fig. 6 eine Kennlinie der mittleren Batteriespannung über den Entladegrad bei Zwischenladung der Batterie;

Fig. 7 ein Blockschaltbild einer Vorrichtung zur Ausführung des Verfahrens,

Fig. 8 die perspektivische Ansicht eines Gerätes, das die Schaltung nach Fig. 7 enthält; und

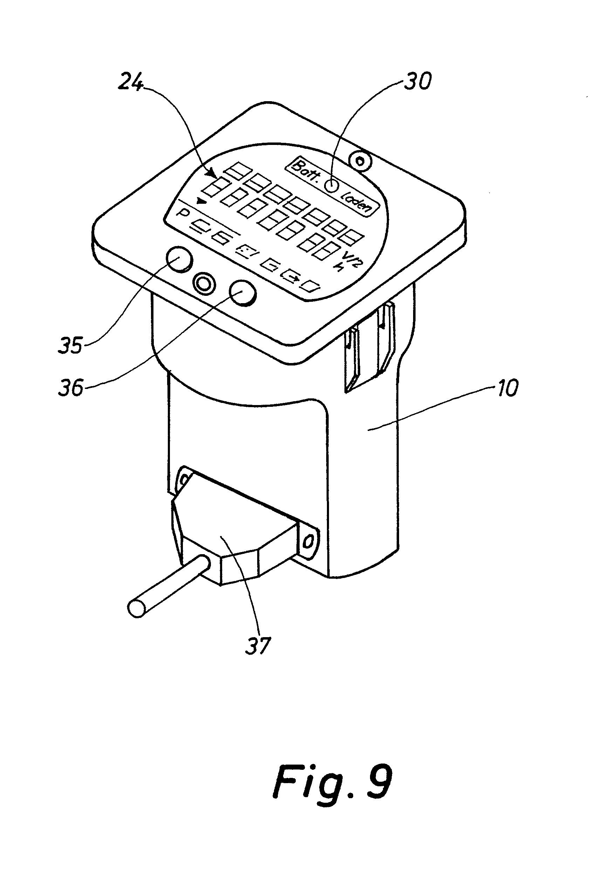

Fig. 9 eine perspektivische Ansicht eines in einem Gehäuse angeordneten Gerätes nach Fig. 8.

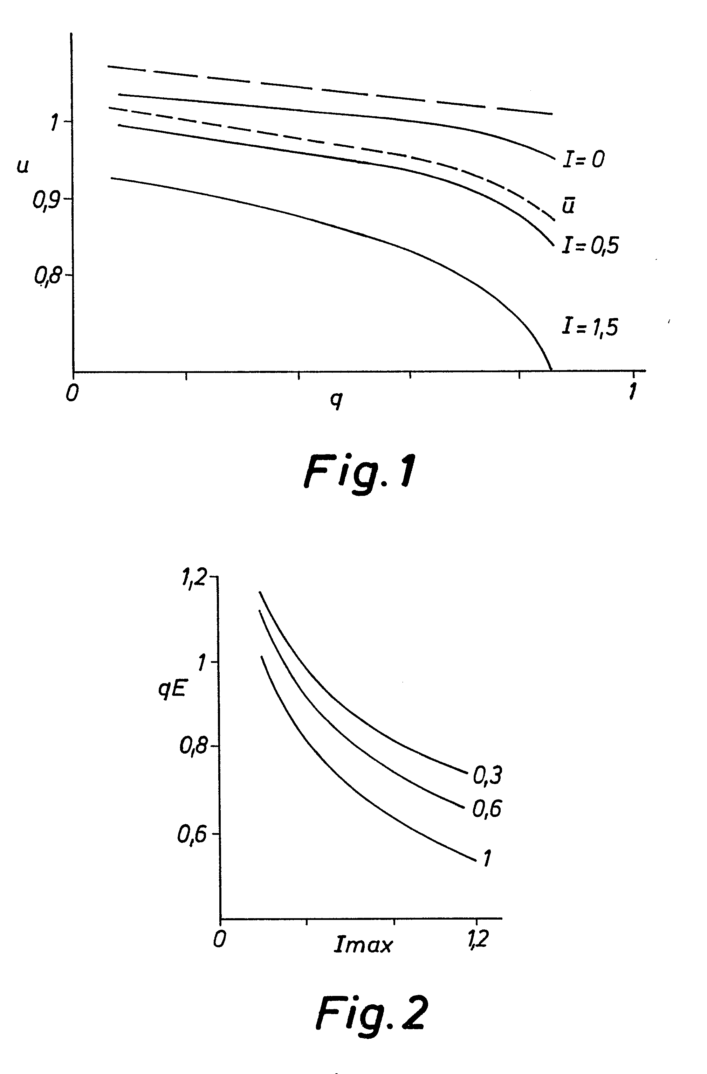

Bei der nachfolgenden Beschreibung wird nun auf die Fig. 1 bis 6 Bezug genommen, um verschiedene Ausführungsformen des erfindungsgemäßen Verfahrens näher zu beschreiben.

Wenn man, wie in Patentanspruch 1 beschrieben, die Klemmenspannung zeitdiskret abtastet, so ist es möglich, aus den einzelnen Meßpunkten den Verlauf der tatsächlichen Batteriespannung herzuleiten. Kennt man das Betriebsverhalten des zu überwachenden Fahrzeuges, so kann man dann z.B. über einen Vergleich der gemessenen Batteriespannung mit einer für das Betriebsverhalten charakteristischen Kennlinie den Ladezustand der Batterie herleiten. Insbesondere bei fahrerlosen Fahrzeugen, die in zunehmendem Maße in automatisierten Werkstätten Einsatz finden, sind immer die gleichen Fahrzyklen zu erwarten, so daß die Speicherung einer einzigen Kennlinie, die bei einer Versuchsfahrt gewonnen werden kann, ausreicht.

Vorzugsweise gibt man dann ein Warnsignal ab, wenn die Batterie auf im wesentlichen 20 % ihrer Nennkapazität entladen ist. Dadurch kann man die eingangs beschriebene nachhaltige Schädigung der Batterie vermeiden. Vorzugsweise wird eine definierte Zeitdauer nach Abgabe des Warnsignales die Stromabgabe unterbrochen, damit keine (fahrlässige) Schädigung der Batterie trotz Abgabe des Warnsignales auftreten kann.

Ein wesentliches Problem bei der Spannungsmessung an der im Betrieb befindlichen Batterie besteht darin, daß während der Batteriebelastung ein Spannungseinbruch (Innenwiderstand der Batterie) auftritt und die Batterie direkt nach Beendigung der Belastung aufgrund der Diffusions-bzw. Strömungsgeschwindigkeiten der Säure nicht sofort wieder ihre Ruhespannung erreicht. Bei einer bevorzugten Ausführungsform der Erfindung zieht man die während einer Stromentnahme vorliegenden Meßwerte nicht zur Beurteilung des Ladezustandes heran, sondern wartet nach Beendigung der Stromentnahme eine definierte Zeitspanne, die zur "Erholung" der Batterie dient, bis man einen neuen Abtastwert der Ladezustandsbeurteilung zugrundelegt. Hier spielt es also eine sehr wichtige Rolle, daß die Klemmenspannung zu definierten Zeitpunkten abgetastet und das Meßergebnis nicht kontinuierlich der Beurteilung des Ladezustandes zugrunde gelegt wird. Die dadurch erhältliche Anzeige wird also durch Lasteinbrüche der Klemmenspannung nicht beeinflußt. Diese Art der Messung eignet sich selbstverständlich nicht für kontinuierlich betriebene Fahrzeuge (z.B. Busse), da' dort sehr lang dauernde Lastzustände zu erwarten sind, während derer nur der letzte in einer Betriebspause gewonnene Meßwert angezeigt werden kann.

Bei einer anderen bevorzugten Ausführungsform der Erfindung errechnet man aus zwei zuvor erhaltenen Abtastwerten, zwischen denen also eine Batteriebelastung aufgetreten ist, in den Zeitintervallen, in denen die Batterie belastet wird, eine Kurve, welche die fiktive Ruhespannung über die Zeit repräsentiert und verfolgt diese Kurve (ggf. Gerade) bei der Anzeige des Ladezustandes. Hier wird also gemäß der vorliegenden Erfindung davon ausgegangen, daß die Batteriekapazität und damit die Klemmenspannung während der aktuellen Entladungsphase ähnlich der zuvor beobachteten und mit zwei Meßpunkten definierten Entladungsphase absinkt.

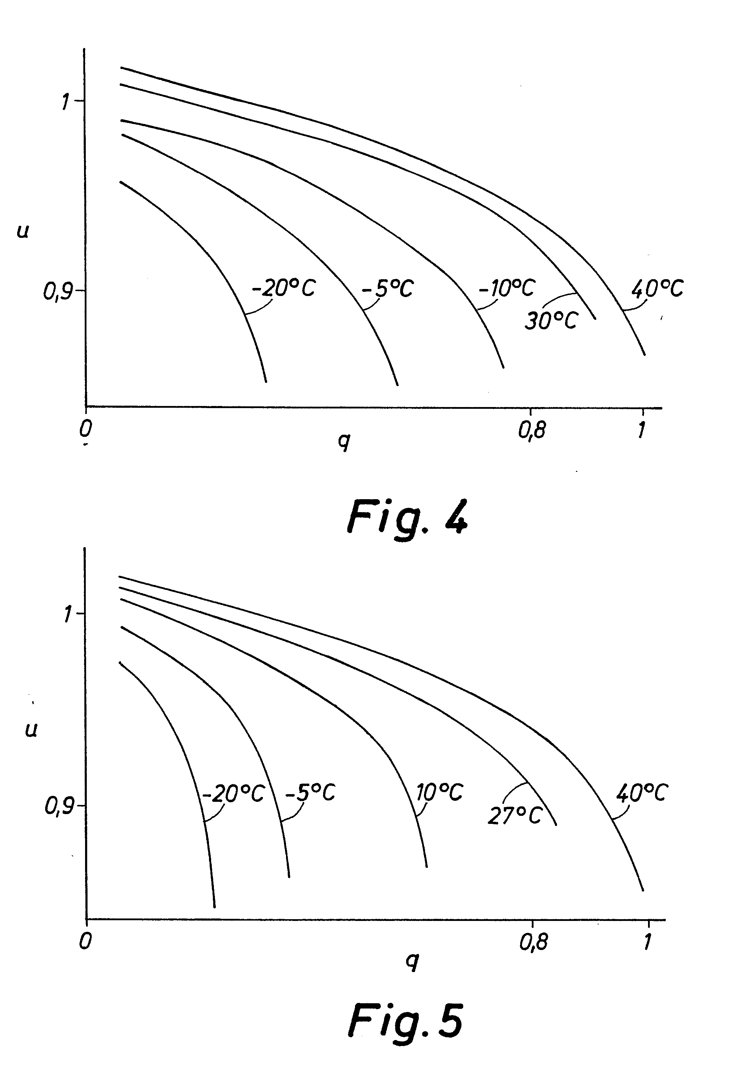

Vorzugsweise wird aber bei den zuvor beschriebenen Verfahren der der Batterie entnommene Momentanstrom bestimmt, über die Zeit gemittelt und der mittlere Strom zur Bestimmung bzw. als Parameter derjenigen von mehreren Kennlinien zugrunde gelegt, die für diesen mittleren Strom die Spannungs-/Entlade-Kennlinie repräsentieren. Auf diese Weise kann man z.B. in dem in Fig. 1 gezeigten Kennlinienfeld von Kennlinie zu Kennlinie "springen", was dann wichtig ist, wenn das Betriebsverhalten des Fahrzeuges nicht voraussehbar und konstant ist. Diese Vorgehensweise ist besonders dann sehr vorteilhaft, wenn Fahrzeuge sehr unterschiedlich betrieben werden, wie sich dies aus Fig. 1 leicht ersehen läßt. Wenn man nämlich von einem mittleren Entladestrom I = 0,5 (Relativwert) ausgeht und diese Kennlinie allein der Herleitung des Ladezustandes zugrundelegt, so wird die Anzeige dann sehr fehlerhaft sein, wenn das Fahrzeug plötzlich mit einem höheren Entladestrom (I = 1,5) betrieben wird. In diesem Fall wird also bei einer vorliegenden Spannung von z.B. U = 0,9 angezeigt, daß die Batterie annähernd entladen ist, obwohl tatsächlich noch eine sehr große Restkapazität zur Verfügung steht. Ähnliches geht aus Fig. 3 hervor, wobei in dieser Abbildung die Stromstärke in Pfeilrichtung steigt bzw. die Gesamtentladedauer der Batterie in Pfeilrichtung sinkt.

Bei einer anderen bevorzugten Ausführungsform der Erfindung bestimmt man (durch zeitdiskrete Abtastung) den der Batterie entnommenen Momentanstrom und legt diesen zur Bestimmung derjenigen von mehreren Kennlinien (siehe Fig. 2) zugrunde, die für den bestimmten Zeitverlauf des Stromes die Maximalstrom-/erreichbarer-Entladegrad-Kennlinie repräsentiert. Es hat sich nämlich gezeigt, daß der der Batterie entnommene Momentanstrom einen wesentlichen Einfluß auf die der Batterie entnehmbare Kapazität hat. Vorzugsweise werden die Kennlinienfelder von Fig. 1 und Fig. 2 gemeinsam zur Bestimmung des Entladegrades bzw. Ladezustandes herangezogen.

Die Bestimmung des der Batterie entnommenen Momentanstroms wird bei einer bevorzugten Ausführungsform der Erfindung aus einem Vergleich der unter Last vorliegenden Klemmenspannung mit einem Kennlinienfeld hergeleitet, das den Spannungsverlauf der Klemmenspannung abhängig vom momentanen Entladungsgrad wiedergibt. Ein solches Kennlinienfeld ist in der Fig. 3 gezeigt. In diesem Fall wird also das Kennlinienfeld nach Fig. 3 zur Strombestimmung verwendet, während die entnehmbare Kapazität aus den Kennlinienfeldern nach den Fig. 1 und 2 errechnet wird. Da als aktueller Meßwert nur die Klemmenspannung vorliegt, geht man davon aus, daß im wesentlichen der bei der letzten (zurückliegenden) Messung erhaltene q-Wert (Entladegrad) im wesentlichen noch korrekt ist und errechnet daraus den der Batterie momentan entnommenen Strom. Dieses Verfahren ist zwar naturgemäß fehlerbehaftet, hat aber den Vorteil, daß kein Meßwiderstand oder eine andere Vorrichtung zur Messung des entnommenen Stroms vorgesehen werden muß.

Bei einer anderen bevorzugten Ausführungsform der Erfindung wird der der Batterie entnommene Momentanstrom ebenfalls über eine Abtastmessung bestimmt, wobei eine Messung über magnetfeld-empfindliche Halbleiteranordnungen wie Feldplatte oder Hall-Sensor von besonderem Vorteil ist, da solche Messungen keine Energieverluste mit sich bringen. Darüber hinaus kann eine solche Messung "berührungslos" erfolgen, erfordert also keinen Umbau des Fahrzeuges, wie dies bei Einbau eines Meßwiderstandes der Fall ist.

Wenn batteriebetriebene Fahrzeuge bei im wesentlichen konstanter Umgebungstemperatur betrieben werden, wie dies z.B. in Fabrikhallen meist der Fall ist, so ist eine Berücksichtigung der Batterietemperatur nicht notwendig.

Um aber den Einfluß der Umgebungstemperatur von vornherein auszuschalten und das Verfahren somit bei allen vorkommenden Fällen verwenden zu können, wird bei einer bevorzugten Ausführungsform der Erfindung die Batterietemperatur bestimmt und über ein Kennlinienfeld (Fig. 4 und 5) der Herleitung des Entladezustandes der Batterie zugrundegelegt. Insbesondere dann, wenn das Fahrzeug z.B. in einem Kühlhaus betrieben wird, ist diese bevorzugte Ausführungsform der Erfindung besonders vorteilhaft, da wie aus den Abbildungen 4 und 5 hervorgeht, der Zusammenhang zwischen Batteriespannung und Entladegrad sehr stark temperaturabhängig ist. Weiterhin ist es von Vorteil, wenn man für die verschiedenen Zeitverläufe der Batteriebelastung verschiedene Kennlinienfelder zur Bestimmung des Ladezustandes heranzieht, da bei gleicher Klemmenspannung je nach Art der Belastung (Dauerbelastung in Fig. 4, - schwankende Belastung in Fig. 5) verschiedene Entladegrade vorliegen.

Vorzugsweise leitet man die Parameter zur Bestimmung der momentan anwendbaren Kennlinie aus einer gleitenden Mittelwertsbildung mit definiertem Zeitfenster über die Meßgröße her. Dies gilt sowohl für die Spannungsmessung als auch für die (gegebenenfalls erfolgende) Strommessung bzw. Strom-Errechnung. Man geht hierbei davon aus, daß eine länger zurückliegende Belastungs-"Art" der Batterie, also die Belastung z.B. mit einem sehr hohen Strom im Laufe der Zeit an Einfluß auf das Batterie-"Verhalten" verliert, während die gerade zurückliegenden Belastungsarten die Hauptrolle spielen. Dies wäre z.B. dann der Fall, wenn ein batteriebetriebenes Fahrzeug, z.B. ein Hochregalstapler, zu Beginn der Schicht eine Reihe von - schweren Lasten in die obersten Regalfächer laden muß und nach dieser starken Belastung nur noch geringe Lasten in Bodennähe zu bewegen sind.

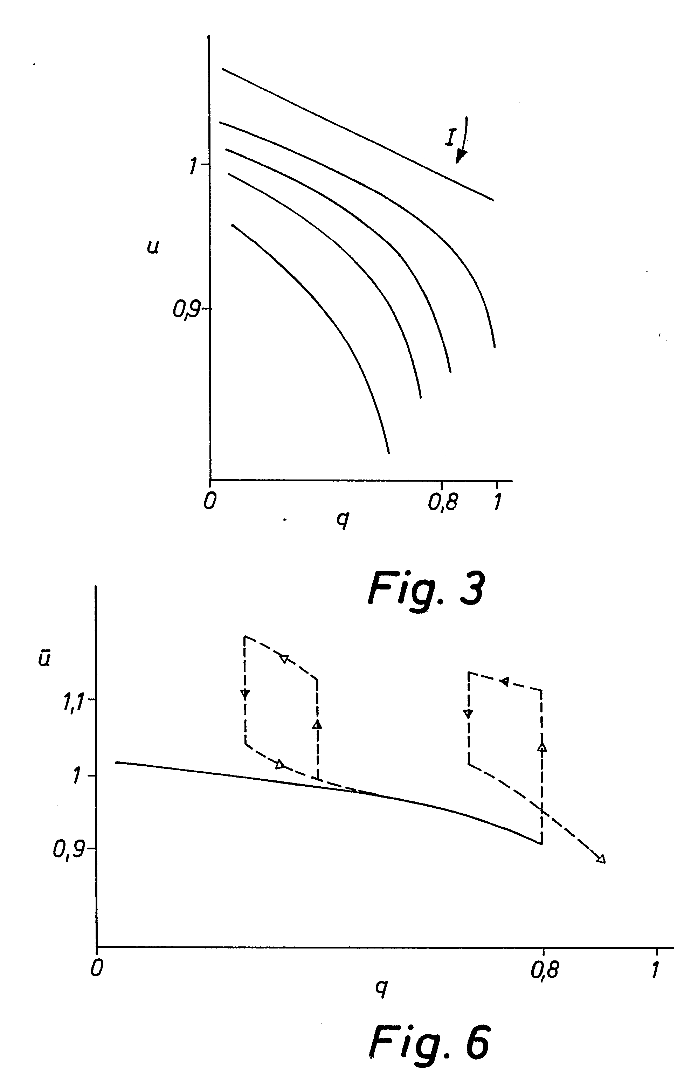

Eine weitere bevorzugte Ausführungsform des erfindungsgemäßen Verfahrens ist insbesondere dann mit Vorteil anwendbar, wenn die Batterie des Fahrzeuges immer wieder zwischengeladen wird, was zum einen bei Nutzbremsung des Fahrzeuges der Fall ist, insbesondere aber bei fahrerlosen Fahrzeugen auftritt, die an ihren End-oder auch an Zwischenpositionen (Wartestellung an der Maschine) über Stromschienen zwischengeladen werden. Der Verlauf der mittleren Batteriespannung in einem solchen Fall ist für zwei Zwischenladevorgänge in Fig. 6 aufgezeigt. Während der Aufladung läuft also die mittlere Batteriespannung (bei einem höheren Niveau entsprechend der höheren Ladespannung) auf der Entladekennlinie zurück und beginnt wieder von neuem. Dieser Neubeginn liegt aber nicht exakt auf der Entladekennlinie, wie sie ohne Zwischenladung aussehen würde, da während des Ladevorganges zusätzlich zum Speichern von Energie noch ein Säureausgleich stattfindet, die Batterie sich also "erholt". Hierbei ist der Einfluß der "Erholung" umso größer, je mehr die Batterie zum Ladebeginn schon entladen ist.

Wenn man, wie im Patentanspruch 14 beschrieben, gemäß der zweiten Alternative der Erfindung eine Bestimmung der tatsächlich entnommenen Ladung durchführt und diesen Wert mit der anfänglich gespeicherten Ladung vergleicht, so wird erfindungsgemäß ebenfalls mindestens eine Kennlinie herangezogen, um die zur Verfügung stehende Restladung zu beurteilen. Wie vorteilhaft dies ist, wird bei Betrachtung z.B. von Fig. 4 oder Fig. 5 klar, da die bei niederen Temperaturen der Batterie tatsächlich entnehmbare Ladung wesentlich geringer ist als die anfänglich (bei höheren Temperaturen) in der Batterie vorhandene Ladung.

Bei einer bevorzugten Ausführungsform der erfindungsgemässen Verfahren geht man bei der Anzeige des Ladezustandes der Batterie dann von einer auf ihre Nennkapazität aufge ladenen Batterie aus, wenn nach dem Abklemmen einer Batterie und einem erneuten Anklemmen einer (gegebenenfalls anderen) Batterie deren Klemmenspannung bei mindestens 2,09 V pro Zelle liegt. Es wird also hier lediglich die Klemmenspannung abgetastet und danach entschieden, ob nunmehr von einer frisch aufgeladenen Batterie auszugehen ist. Eine weitere Eingabe von Daten ist zunächst nicht notwendig.

Wenn man bei eingebauter Batterie lädt, so ist es von Vorteil, daß man dann von einer wieder aufgeladenen Batterie ausgeht, wenn die Gasungsspannung (2,35 bzw. 2,45 V pro Zelle) eine definierte Zeitdauer überschritten wurde. Mit dem erfindungsgemäßen Verfahren kann man also bei eingebauter Batterie gleichzeitig eine Ladekontrolle durchführen.

Vorzugsweise bestimmt man gleichzeitig mit dem Ladezustand auch die seit Einstellen eines Null-Wertes abgelaufene Betriebszeit des Fahrzeuges und zeigt diese bei Bedarf gleichzeitig oder auch auf gesonderte Abfragesignale hin an. Es wird also parallel zur Bestimmung des Ladezustandes der Batterie auch noch eine Bestimmung des ganz allgemeinen Betriebszustandes des Fahrzeuges durchgeführt, wobei die Betriebsdauer ein wesentlicher Parameter bei der Bestimmung des Betriebszustandes ist. Diese Betriebsdauer kann z.B. auch als noch zur Verfügung stehende Betriebsdauer bis zu dem Zeitpunkt angezeigt werden, an dem eine Fahrzeugwartung durchzuführen ist. Wenn man so vorgeht, hat man alle für den störungsfreien Betrieb notwendigen Daten bei der Hand, soweit diese voraussehbar sind.

Besonders einfach und den tatsächlichen Beanspruchungsverhältnissen am besten angepaßt, läßt sich die Betriebszeit dann feststellen, wenn man diejenigen Zeitintervalle aufsummiert, in denen der Batterie Strom entnommen wird. Nachdem bei batteriebetriebenen Fahrzeugen alle Bewegungs vorgänge, also alle Vorgänge, die Verschleißteile betreffen, welche zu warten sind, über einen Entnahmestrom erfolgen, entspricht die tatsächliche Betriebszeit eben dieser Stromentnahmezeit. Um nun auch noch die Zeiten in die Berechnung der Betriebszeit mit einfließen zu lassen, in denen das Fahrzeug während der Arbeitszeit des Fahrzeugführers kurze Betriebspausen (hinsichtlich der Stromentnahme) einlegt, ist es von Vorteil, wenn man ein definiertes Zeitintervall nach Beendigung der Stromentnahme auch noch der Betriebszeit hinzurechnet. Wenn man davon ausgeht, daß entsprechend einem zuvor festgestellten mittleren Betriebsverhalten die Betriebsunterbrechungspausen (Pausen zwischen Stromentnahmezyklen) einen gewissen Maximalwert nicht überschreiten, so kann man mit dem zuvor beschriebenen Verfahren sehr gut beurteilen, welche mittleren Betriebszeiten beim Fahrzeug aufgelaufen sind. Diese Art des Vorgehens ist wesentlich genauer, als die bisher oft geübte Methode, bei der man als Betriebszeit denjenigen Zeitraum definiert, in dem ein Schlüsselschalter eingeschaltet ist.

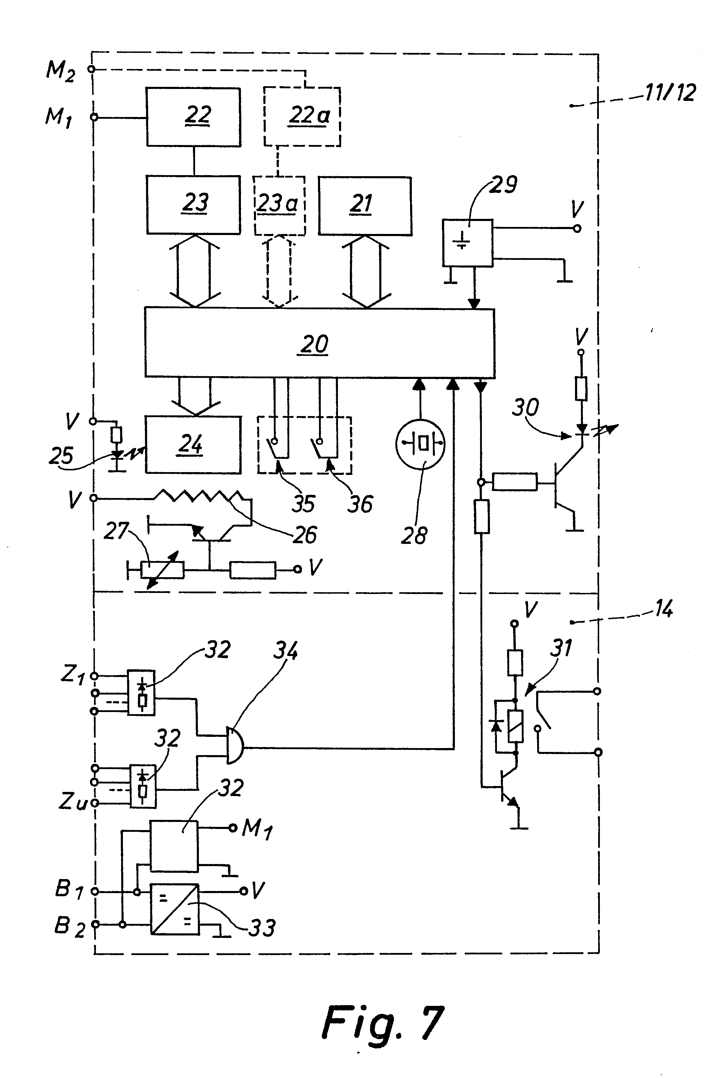

Im folgenden wird anhand der Fig. 7 eine Anordnung zur Durchführung des eingangs beschriebenen Verfahrens näher erläutert, wobei diese Anordnung auf einem Mikroprozessor ($\mu$P) basiert. Der $\mu$P 20 weist die üblichen internen Speicher zum wahlfreien Zugriff auf und steht darüber hinaus mit einem externen Speicher 21 in Verbindung. Dieser Speicher 21 ist vorzugsweise als EEPROM ausgebildet und dient zur Speicherung der eingangs erwähnten Kennlinien. Zur Stromversorgung ist eine Spannungsüberwachungsschaltung 29 mit einer Lithiumbatterie vorgesehen, damit bei Abklemmen der zu überwachenden Batterie die in den flüchtigen Speichern gespeicherten Daten nicht verlorengehen.

Die Abtastung der Batteriespannung sowie gegebenenfalls des in die bzw. aus der Batterie fließenden Stromes geschieht über einen spannungsgesteuerten Oszillator 22, dessen Ausgangsimpulse von einem Zähler 23 gezählt werden. Der Zähler 23 wird vom $\mu$P 20 in äquidistanten Zeiträumen abgefragt und wieder auf Null gesetzt. Diese Art der Abtastung ist von besonderem Vorteil auf dem hier vorliegenden Gebiet, da die im Bordnetz eines batteriebetriebenen Fahrzeuges unvermeidbar auftretenden sprung-bzw. impulsförmigen Spannungsschwankungen über eine VCO-Abtastung besonders wirksam geglättet werden können. Parallel zur Batteriespannungsabtastung über den Eingang M1 kann bei Bedarf ein Eingang M2 vorgesehen sein, der über einen zweiten spannungsgesteuerten Oszillator 22a und einen zweiten Zähler 23a arbeitet.

Die Taktfrequenz für den μP 20 wird von einem Taktoszillator 28 geliefert. Hierbei ist es von besonderem Vorteil, wenn der Taktoszillator 28 entweder in seiner Frequenz veränderbar oder durch einen externen Taktoszillator zeitweise ersetzbar ist, wobei dann gleichzeitig auch der Zähler 23 mit einem Ausgangsstellenumschalter versehen ist. Wenn die Anordnung so aufgebaut ist, so kann man einen schnellen Testlauf durchführen, indem man den μP 20 mit einer wesentlich gesteigerten Taktrate betreibt und das entsprechende Test-Batteriespannungs-/Strommuster über die VCO's 22 bzw. 22a eingibt und dabei gleichzeitig die Zähler 23, 23a an entsprechend höherwertigen Stellen (die mit niederwertigen Stellen vertauscht sind) abfragt. Dieser Stellentausch muß vorgenommen werden, damit die der Spannung proportionalen Ausgangsfrequenzen der VCO's gleich bleiben und dennoch die über ein definiertes Zeitintervall gezählten Ausgangspulse den korrekten, simulierten Wert anzeigen können.

Bei einer anderen, hier nicht gezeigten bevorzugten Ausführungsform der Erfindung wird die Verbindungsleitung zwischen dem Zähler 23 und dem μP 20 während des Testlaufs aufgetrennt und das Testmuster direkt als Digitalwert eingegeben.

Zur Anzeige der wie eingangs beschrieben errechneten Werte dient eine LCD-Anzeige 24, die vom μP 20 direkt angesteuert werden kann. Damit die Anordnung auch bei niedrigen Temperaturen ein einwandfreies Ablesen der Werte ermöglicht, ist es von Vorteil, in der Nähe der LCD-Anzeige 24 ein Heizelement 26 vorzusehen. Die Steuerung des Heizelementes 26 geschieht vorteilhafterweise durch einen temperaturabhängigen Widerstand 27, der den Heizstrom über einen Transistor steuert. Der temperaturabhängige Widerstand 27 ist vorzugsweise in der Nähe der LCD-Anzeige 24 angeordnet. Das Heizelement 26 ist vorzugsweise ein Peltier-Element, auf dem die LCD-Anzeige sitzt.

Zur Beleuchtung ist es von Vorteil, an einer entsprechenden Stelle über eine Leuchtdiode 25 die LCD-Anzeige zu beleuchten.

Neben der LCD-Anzeige 24 ist eine Leuchtdiode 30 vorgesehen, um ein noch besser sichtbares Warnsignal dann abzugeben, wenn die Batteriekapazität an die Grenze der erlaubten bzw. der erreichbaren Restkapazität kommt. Dieser Leuchtdiode 30 kann ein Relais 31 parallel geschaltet sein, das bei Erreichen dieses Grenzwertes ein akustisches Signal abgibt und/oder bestimmte Lasten (Motoren) abschaltet.

Um die Anordnung bei verschiedenartigen Fahrzeugen bzw. bei verschiedenen Batteriesätzen verwenden zu können, ist es von Vorteil, wenn Spannungsanpassungsschaltungen 32, 33 vorgesehen sind, über welche die Klemmenspannung auf einen, der vorrichtungsinternen Arbeitsspannung angepaßten Wert herabsetzbar ist. Hierbei wird zum einen ein DC/DC-Wandler 33 vorgesehen, der die anliegende Batteriespannung in eine für den Eingang der Spannungsüberwachungsschaltung 29 passende Spannung umsetzt, sowie Anpassungsschaltungen 32, welche die Batteriespannung in eine Meßspannung (für die spannungsgesteuerten Oszillatoren) bzw. Zählimpulsspannungen (Eingänge Z1 bis Zn) in entsprechend niedrigere Spannungswerte umwandeln, die dann vom μP 20 bearbeitet werden können. Weiterhin ist es hier von Vorteil, wenn zwei Gruppen von Zähl-Spannungsumsetzern 32 ein ODER-Gatter 34 nachgeschaltet ist, dessen einer Eingang invertiert ist. Auf diese Weise ist es möglich, sowohl positive wie auch negative Spannungsflanken zählbar zu machen. Über die Eingänge Z1 bis Zn ist es möglich, den μP 20 mit einem Betriebsschalter des Fahrzeuges zu verbinden, oder auch verschiedene Lasten abzufragen, so daß z.B. die Betriebszeit des Hubmotors bei einem Stapler unabhängig von der Betriebszeit des Fahrmotors erfaßt werden kann. Derartige Erfassungen sind von großem Vorteil, wenn man z.B. aus kaufmännischer Sicht eine Rationalisierung auf konkrete Daten basieren lassen will. Darüber hinaus sind derart getrennt erfaßte Daten für die Wartung der Fahrzeuge von großem Vorteil, überflüssige Wartungsarbeiten an wenig belasteten Motoren können dann entfallen, wenn die Zähldaten getrennt gespeichert werden.

Vorzugsweise sind gesonderte Abtastmittel zum Abtasten der Batterietemperatur vorgesehen und mit dem μP verbunden. Dies ist in Fig. 7 nicht gezeigt. Bei derartigen gesonderten Abtastmitteln genügt im allgemeinen eine Abtastung mit geringerer Bit-Zahl, da eine Grobeinteilung in Temperaturbereiche zum Heraussuchen der momentan aktuellen Kennlinie hinreichend genau ist.

Weiterhin sind mit dem μP 20 zwei Programmiertasten 35, 36 verbunden, über die Steuerdaten in den μP 20 eintastbar sind. Derartige Steuerdaten können zum einen für die Messung relevante Daten (z.B. Nennkapazität der Batterien, Wartungsintervall usw.) sein, zum anderen können über diese Tasten Abfragen erfolgen, damit eine einzige Anzeige zum ständigen Anzeigen der Batterierestkapazität und alternativen Anzeigen von z.B. der bis zur nächsten Wartung verbleibenden Zeit genügt. Vorzugsweise ist hierbei mindestens eine der Tasten (35 oder 36) so unzugänglich montiert, daß diese nur von "befugten" Personen bedient werden kann. Man kann in diesem Fall auch die entsprechende Taste an einem externen Prüf-/Überwachungsgerät vorsehen und nur über eine anzukoppelnde Steckerverbindung aktivieren, was die Unzugänglichmachung für Unbefugte besonders wirksam macht. Weiterhin ist es möglich, in Reihe mit einer der Programmiertasten 35 oder 36 einen Schlüsselschalter vorzusehen, so daß die Taste bei geöffnetem Schlüsselschalter und abgezogenem Schlüssel "inaktiv" ist.

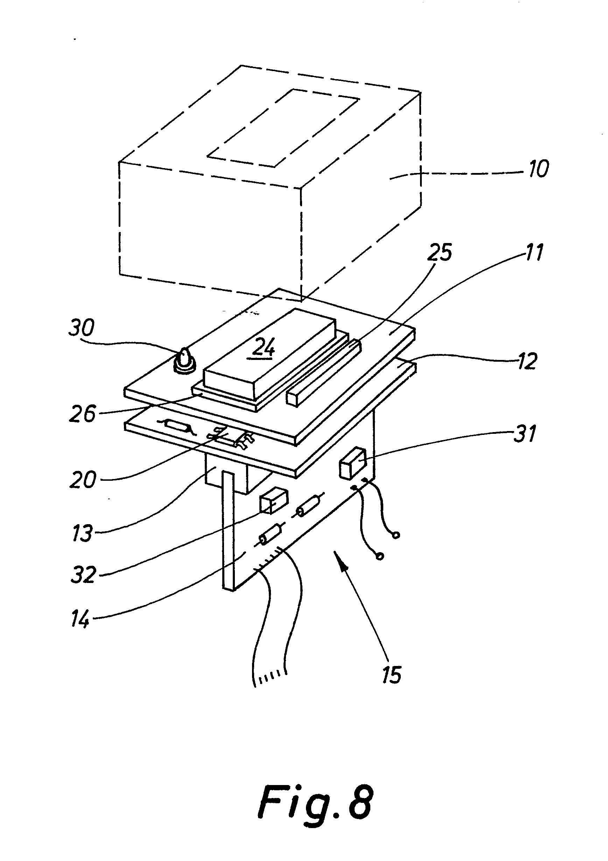

Der konstruktive Aufbau des Gerätes erfolgt vorzugsweise im wesentlichen in zwei Abschnitten, wobei der eine Abschnitt all diejenigen Bauteile bzw. Baugruppen enthält, die nach der abzutastenden Batteriespannung dimensioniert sein müssen, während alle übrigen Bauteile auf einer (oder mehreren) anderen Platine sitzen. Dies soll anhand der Fig. 8 verdeutlicht werden. Wie aus dieser Abbildung ersichtlich, ist eine Doppel-Platine 11/12 vorgesehen, wobei die obere Platine 11 die LCD-Anzeige 24 mit dazugehöriger Beleuchtung 25 und Heizung 26 sowie die Warn-LED 30 enthält, während die darunterliegende Platine den $\mu$P 20 und die weiteren in Fig. 7 strichliert umrahmten Teile enthält. Alle kundenspezifischen Teile, also z.B. das Relais 31 (das nicht für jedes Fahrzeug benötigt wird) oder die Spannungsanpassungsschaltungen 32/33 werden auf einer gesonderten Platine 14 angeordnet, die mit der Doppelplatine 11/12 entweder über eine Steckerleiste 13 oder über entsprechende mehrpolige Verbindungskabel verbunden ist. Bei einer derartigen Ausgestaltung kann man somit Grundgeräte konzipieren, die durch einfaches Verbinden mit kundenspezifischen Platinen zum "Spezialinstrument" werden.

Bei dieser Anordnung ist es von Vorteil, wenn die, die kundenspezifischen Bauteile enthaltende Platine 14, die in Fig. 8 gezeigte senkrechte Lage zu den übrigen Platinen einnimmt, weil dann ein leichtes Installieren bzw. Aus wechseln in vorgefertigten Geräten möglich ist, bei denen die oberen Platinen 11/12 bereits in einem Gehäuse 10 montiert sind.

Der Anschluß des gesamten Gerätes am damit auszurüstenden Fahrzeug erfolgt vorzugsweise über einen Stecker 37, so daß das Gehäuse 10 (mit Inhalt) auf einfache Weise montiert und abgenommen werden kann, wobei man dann das Gehäuse 10 besonders leicht bereits beim Hersteller wasserdicht ausführen, gegebenenfalls sogar mit Kunstharz vergießen kann.

Wie aus obiger Darstellung hervorgeht, besteht ein wesentlicher Punkt der Erfindung darin, daß durch die Art der Datenabtastung und Auswertung ein Gerät geschaffen wird, das den jeweiligen Anforderungen besonders einfach anpaßbar ist. Man kann durch die Möglichkeit der Speicherung von Kennlinien beliebiger Art von einer reinen Spannungsmessung zu einer Spannungs-/Strommessung oder einer reinen Ladungsmessung übergehen, je nach dem wie der Einsatzbereich des Fahrzeuges dies erfordert. Es ist auf diese Weise möglich, sowohl Fahrzeuge mit intermittierendem Betrieb als auch solche mit kontinuierlichem Betrieb zu überwachen, da man von der einen Meßmethode (relevanten Kurvenschar) auf eine andere Meßmethode übergehen kann. Die Genauigkeit der Anzeige ist gegenüber den herkömmlichen Geräten um ein vielfaches höher, da eine Vielzahl von Parametern aufgrund der Verfahrens-bzw. Gerätekonzeption in die Messung Eingang finden kann. Die oben beschriebenen Details werden somit auch für sich alleine gesehen als erfindungswesentlich beansprucht.

Ein wesentlicher Vorteil des erfindungsgemäßen Verfahrens besteht weiterhin darin, daß man die in der Batterie an sich zur Verfügung stehende gespeicherte Ladung besser als bisher ausnutzen kann, da eine Unterscheidung zwischen momentan entnehmbarer und tatsächlich entnommener Ladung ge troffen wird. Bei Anwendung dieses Verfahrens ist es somit dem Fahrzeugführer möglich, der Batterie dann eine "Erholungspause" zu gönnen, wenn die Batteriespannung zwar weit abgesunken ist, an sich aber noch gespeicherte Ladung zur Verfügung steht. Wesentlich ist hierbei, daß dennoch der maximale Entladegrad nicht überschritten wird, wie dies bei einem solchen Betriebsverhalten sonst der Fall war.

## Ansprüche

1. Verfahren zur Überwachung des Bereitschaftszustandes eines batteriebetriebenen Fahrzeuges, wobei man mindestens die Klemmenspannung an der Batterie mißt,
dadurch gekennzeichnet, daß man die Klemmenspannung zeitdiskret abtastet, das Ergebnis mit einem Punkt auf mindestens einer (Entlade-) Spannungskennlinie (u (q))vergleicht, deren Variable (q) der momentane Entladungsgrad ist, und daß man mindestens die Differenz zwischen momentanem Entladegrad (q) und erreichbarem Ladegrad (qE) entsprechend der Kennlinie als Ladezustand anzeigt.

2. Verfahren nach Anspruch 1,
dadurch gekennzeichnet, daß man das Ergebnis der Abtastung nur dann dem Vergleich zugrundelegt, wenn die Batterie-Ruhespannung über eine definierte Zeitspanne nach Belastung der Batterie vorliegt.

3. Verfahren nach einem der vorhergehenden Ansprüche,
dadurch gekennzeichnet, daß man während einer Belastung der Batterie aus mindestens zwei zuvor erhaltenen Abtastwerten mit dazwischen liegender Belastung den Verlauf einer, die fiktive Ruhespannung über die Zeit repräsentierenden Geraden errechnet und den errechneten Wert als fiktiven Abtastwert der weiteren Rechnung/Anzeige zugrundelegt.

4. Verfahren nach einem der vorhergehenden Ansprüche,

**dadurch gekennzeichnet,** daß man den der Batterie entnommenen Momentanstrom (I) bestimmt, über die Zeitmittelt ( $\bar{I}$ ) und den mittleren Strom ( $\bar{I}$ ) zur Bestimmung (Parameter) derjenigen von mehreren Kennlinien zugrundelegt, die für diesen mittleren Strom ( $\bar{I}$ ) die Spannungs-/Entladegrad-Kennlinie repräsentiert (Fig. 1).

5. Verfahren nach einem der vorhergehenden Ansprüche,

**dadurch gekennzeichnet,** daß man den der Batterie entnommenen Momentanstrom (I) bestimmt und zur Bestimmung (Parameter) derjenigen von mehreren Kennlinien zugrundelegt, die für den bestimmten Zeitverlauf des Stromes die Maximalstrom-/ erreichbarer -Entladegrad-Kennlinie (Imax/qE) repräsentiert (Fig. 2).

6. Verfahren nach einem der Ansprüche 2 bis 5,

**dadurch gekennzeichnet,** daß man den der Batterie entnommenen Momentanstrom (I) aus einem Vergleich der unter Last vorliegenden Klemmenspannung (u) mit einem Kennlinienfeld bestimmt, das den Spannungsverlauf (u) abhängig vom momentanen Entladungsgrad (q) wiedergibt (Fig. 3).

7. Verfahren nach einem der vorhergehenden Ansprüche,

**dadurch gekennzeichnet,** daß man die Batterietemperatur (T) bestimmt und der Bestimmung der momentan anwendbaren Kennlinie (mehrdimensionales Kennlinienfeld) zugrundelegt (Fig. 4, 5).

8. Verfahren nach einem der vorhergehenden Ansprüche,

**dadurch gekennzeichnet,** daß man dann, wenn die Klemmenspannung ( $\bar{u}$ ) um einen definierten Wert über dem beim momentanen Entladegrad (q) zu erwartenden Ruhespannungswert oder über der momentanen mittleren Klemmenspannung (u) liegt (Erholung Zwischenladung), die Neubestimmung von anwendbaren Kennlinien unterbricht, bis eine definierte Belastung der Batterie (Zusammenbruch der Klemmenspannung, Strom) festgestellt wurde (Fig. 6).

9. Verfahren nach Anspruch 8,

**dadurch gekennzeichnet,** daß man die Schlußspannung (us) bei Bestimmung des (20 %) Entladungszustandes vorzugsweise durch Vergleich mit der mittleren Klemmenspannung ( $\bar{u}$ ) abhängig von dem Zeitpunkt bzw. Entladegrad (q) bestimmt, bei dem mit einer Zwischenladung begonnen wurde (Fig. 6).

10. Verfahren zur Überwachung des Betriebszustandes eines batteriebetriebenen Fahrzeuges, wobei man mindestens den aus der bzw. in die Batterie fließenden Strom mißt,

**dadurch gekennzeichnet,** daß man den der Batterie entnommenen Momentanstrom (I) zeitdiskret abtastet, die Abtastwerte aufsummiert, das Ergebnis mit einem Punkt auf mindestens einer Kapazitäts-Kennlinie vergleicht, deren Anfangspunkt der Nennkapazität einer vollen Batterie entspricht und deren Variable mindestens der Verlauf der entnommenen Stromstärke und/oder der Temperatur ist, und daß man die Differenz zwischen dem Summenwert und dem 20 %-Kapazitätswert entsprechend der Kennlinie als Ladezustand anzeigt.

11. Verfahren nach einem der vorhergehenden Ansprüche,

**dadurch gekennzeichnet,** daß man gleichzeitig mit der Bestimmung des Ladezustandes die seit Einstellen eines Null-Wertes abgelaufene Betriebszeit des Fahrzeuges bestimmt und bei Bedarf oder gleichzeitig anzeigt, insbesondere daß man die abgelaufene Betriebszeit mit definierten Wartungszeitintervallen vergleicht und die Differenz (Zeitintervall bis zur nächsten Wartung) bei Bedarf oder gleichzeitig anzeigt, wobei man vorzugsweise als Betriebszeit diejenigen Zeitintervalle aufsummiert, in denen der Batterie Strom entnommen wird, und ein definiertes Zeitintervall nach Beendigung der Stromentnahme der Betriebszeit zurechnet.

12. Vorrichtung zur Überwachung des Bereitschaftszustandes eines batteriebetriebenen Fahrzeuges, insbesondere zur Durchführung eines Verfahrens nach einem der Ansprüche 1 oder 10, mit einem Gehäuse (10) mit Sichtfenster, mit Abtastmitteln (22, 23) zum Abtasten der Batteriespannung und/oder des aus der (in die) Batterie fließenden Stroms, mit Auswertmitteln (20, 21) zum Bestimmen des Bereitschaftszustandes des Fahrzeuges und mit Anzeigemitteln (24, 30) zum Anzeigen des Bereitschaftszustandes, wobei die Abtastmittel und die Anzeigemittel mit den Auswertmitteln verbunden sind,

**dadurch gekennzeichnet,** daß die Auswertmittel einen Mikroprozessor (20) mit Taktgenerator (28) und Speichermittel (EEPROM 21) umfassen, in den für die verwendete Batterie des Fahrzeuges charakteristische Daten und/oder Kennlinien speicherbar sind, die vom Mikroprozessor (20) mit den Abtastwerten verglichen werden, wobei der Mikroprozessor (20) aus dem Vergleichsergebnis den Batterie-Ladezustand errechnet und auf den Anzeigemitteln (24, 30) anzeigt, wobei vorzugsweise die Anzeigemittel mindestens eine LCD-Anzeigeeinheit (24) zum symbolischen und/oder numerischen Anzeigen des Ladezustandes und eine selbstleuchtende Anzeigeeinheit (LED 30) zum Abgeben eines Warnsignales bei Überschreitung einer zulässigen Maximalentladung umfassen.

13. Vorrichtung nach Anspruch 12,

**dadurch gekennzeichnet,** daß die LCD-Anzeigeeinheit (24) über ein Heiz-vorzugsweise ein Peltier-Element (26) beheizbar ist, das vorzugsweise über ein temperaturabhängiges Bauteil (NTC 27) ansteuerbar ist.

14. Vorrichtung nach einem der Ansprüche 12 oder 13,

**dadurch gekennzeichnet,** daß die Abtastmittel einen spannungsgesteuerten Oszillator (22) mit nachgeschaltetem, vom Mikroprozessor (20) ausles-und rücksetzbaren Zähler (23) umfassen.

15. Vorrichtung nach einem der Ansprüche 12 bis 14,

**dadurch gekennzeichnet,** daß Programmiertasten (35, 36) mit dem Mikroprozessor (20) verbunden sind, über die Steuerdaten in den Mikroprozessor (20) eintastbar sind, wobei vorzugsweise mindestens eine der Programmiertasten (35, 36) inaktivierbar ist.

16. Vorrichtung nach einem der Ansprüche 12 bis 15,

**dadurch gekennzeichnet,** daß der Taktgenerator (28) und die Abtastmittel (22, 23) über (gehäuse-) externe Mittel (Frequenzvervielfacher, externer Taktgenerator; Stellenumschalter) in seiner Taktfrequenz bzw. in ihrem Übertragungsfaktor heraufsetzbar sind und vorzugsweise zusätzliche Abtastmittel zum Abtasten der Batterietemperatur vorgesehen und mit dem Mikroprozessor (20) verbunden sind.

17. Vorrichtung nach einem der Ansprüche 12 bis 16,

**dadurch gekennzeichnet,** daß die elektrischen/elektronischen Bauteile der Vorrichtung auf mindestens zwei Platinen (11, 12; 14) vorgesehen sind, wobei alle von der abzutastenden Batteriespannung abhängig zu dimensionierenden Bauteile (32, 33) nur (alleine) auf einer der Platinen (Modulplatine 14) angeordnet sind.

18. Vorrichtung nach Anspruch 17,

**dadurch gekennzeichnet,** daß die Modulplatine (14) an das, dem Gehäusefenster gegenüberliegende Gehäuseende angrenzend angebracht ist, während die übrigen Platinen (11, 12) parallel zum Gehäusefenster liegen, wobei vorzugsweise die Modulplatine (14) senkrecht zu den übrigen Platinen (11, 12) angebracht ist.

Fig.1

Fig.2

Fig. 4

Fig. 5

Fig. 3

Fig. 6

0 280 916

Fig. 7

**Fig.8**



Fig. 9

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 626 765 (JAPAN STORAGE BATTERY) <br> * Spalte 2, Zeilen 39-60 * | 1,2 | G 01 R 31/36 <br> H 01 M 10/48 |
| Y | | 4,6,7, 10 | |
| Y | US-A-4 455 523 (NORAND) <br> * Zusammenfassung; Figur 5 * <br> --- | 4,7,10 | |
| Y | EP-A-0 067 589 (FIRING CIRCUITS) <br> * Zusammenfassung * <br> --- | 6 | |
| A | CH-A- 648 936 (KÖCHLER) <br> * Zusammenfassung; Seite 3, rechte Spalte, Zeilen 43-64 * <br> --- | 1-18 | |
| A | GB-A-2 148 518 (LUCAS) <br> --- | | |
| A | US-A-4 638 237 (PULSE) <br> --- | | |
| D,A | FR-A-2 361 754 (SAFT) <br> --- | | |
| D,A | FR-A-2 227 652 (ELEKTRON) <br> --- | | RECHERCHIERTE SACHGEBIETE (Int. Cl.4) |
| D,A | FR-A-2 296 945 (CURTIS) <br> ----- | | G 01 R <br> H 01 M |

Der vorliegende Recherchenbericht wurde für alle Patentansprüche erstellt

| Recherchenort | Abschlußdatum der Recherche | Prüfer |
|---|---|---|
| DEN HAAG | 27-05-1988 | HOORNAERT W. |